Europäisches Patentamt

European Patent Office

Office européen des brevets

(11) Publication number: **0 339 886**
**A2**

# EUROPEAN PATENT APPLICATION

(21) Application number: **89304000.6**

(22) Date of filing: **21.04.89**

(51) Int. Cl.4: **H01L 39/12**

(30) Priority: **28.04.88 US 187098**

(43) Date of publication of application:
**02.11.89 Bulletin 89/44**

(84) Designated Contracting States:
**DE FR GB IT NL**

(71) Applicant: **AMERICAN TELEPHONE AND TELEGRAPH COMPANY**
**550 Madison Avenue**
**New York, NY 10022(US)**

(72) Inventor: **Batlogg, Bertram, Joseph**
**308 Livingston Avenue**
**New Providence New Jersey 07974(US)**
Inventor: **Cava, Robert, Joseph**
**193-D Lakeview Drive RD 2**
**Basking Ridge New Jersey 07920(US)**

(74) Representative: **Johnston, Kenneth Graham et al**
**AT&T (UK) LTD. AT&T Intellectual Property Division 5 Mornington Road**
**Woodford Green Essex, IG8 OTU(GB)**

(54) A-site substituted bismuth oxide superconductors, and devices and systems comprising such a superconductor.

(57) Extensions of a new class of Bi-based superconductive oxides are disclosed. The novel materials have crystal structures (typically perovskite-like) with two inequivalent cation sites (A-site and B-site, respectively), with unmixed B-site occupancy, and all substituents occupying A-sites. In one aspect the inventive oxides have composition $Ba_{1-x}K_xBiO_{3-\delta}$ , with $x \geq 0.3$, and transition temperature $T_c^{onset} \geq 22K$. in another aspect the oxides have composition $ABiO_{3-\delta}$, where A is $X_{1-x-y}M_xM'_y$ , where M is an appropriate dopant element, $M'$ is an appropriate stabilizer element, and X is a large divalent element such as Ba, Sr, or Ca. In a still further aspect the oxides have composition $A_{n+1}Bi_nO_{3n+1-\delta}$, where n is a positive integer greater than 0 and typically less than about 6. These embodiments have a layered structure, in contradistinction from other members of the relevant oxide class. The materials are advantageously produced by a process that comprises heating of the starting materials in a closed system such that an alkali partial pressure greater than 1 atm. (typically greater than 10 atm.) results. Potential uses for the novel materials entail all those for which prior art superconductors have been proposed, or in which they have been used.

EP 0 339 886 A2

# A-SITE SUBSTITUTED BISMUTH OXIDE SUPERCONDUCTORS, AND DEVICES AND SYSTEMS COMPRISING SUCH A SUPERCONDUCTOR

## Field of the Invention

This invention pertains to oxide superconductors, and to apparatus and systems comprising such superconductors.

## Background of the Invention

From the discovery of superconductivity in 1911 to the recent past, essentially all known superconducting materials were elemental metals (e.g., Hg, the first known superconductor) or metal alloys or intermetallic compounds (e.g., $Nb_3Ge$, probably the material with the highest transition $T_c$ known prior to 1986).

In about 1975 superconductivity was discovered in a member of a new class of materials, namely metal oxides. See, for instance, A. W. Sleight et al., Solid State Communications, Vol. 17, page 27 (1975), and U.S. Patent 3,932,315. The bismuth lead oxides of the paper and the '315 patent have crystal structures that are closely related to the well-known perovskite structure (having an $ABO_3$ structure, in which A and B designate appropriate metal elements, with the so-called A-site being crystallographically inequivalent to the B-site) with mixed B-site occupancy. These oxides typically have composition $BaPb_{1-x}Bi_xO_3$, with $0.05 \leq x \leq 0.3$, and become superconducting at temperatures up to about 13K, $T_c$ typically depending on the composition of the material. The maximum $T_c$ was observed for $x \sim 0.25$. Semiconducting behavior is observed from $x = 1$ to about 0.35.

In addition to the Pb-rich bismuth oxides (both Pb and Bi located on B-sites) of the Sleight et al., article, the '315 patent also discloses superconducting Pb-Bi-oxides having, in addition to mixed B-site occupancy, mixed A-site occupancy. None of the Bi-based superconductors known prior to 1987 have $T_c$ greater than about 13K.

In 1986, J. G. Bednorz and K. A. Müller, Zeitschr. f. Physik B-Condensed Matter, Vo. 64, 189, reported the discovery of superconductivity in lanthanum barium copper oxide. This report stimulated worldwide research activity which very quickly resulted in further significant progress.

Recently a prediction was published that leaving the B-site unsubstituted while substituting on the A-site with an appropriate monovalent element, may result in enhanced $T_c$ and marginal stability of the metallic phase region in Bi-based superconductive oxides. See L. F. Mattheiss et al., Physical Review B, Vol. 37, pp. 3745-3746 (1988). Indeed, Mattheiss et al. observed superconductivity in samples of oxide prepared from starting material whose Ba, K and Bi-contents and Ba, Rb and Bi-contents, corresponded to the ratios 0.9 : 0.2, 0.24 : 1 and 0.9 : 0.2 : 1, respectively. The samples exhibited $13K < T_c^{onset} \leq 22$, where $T_c^{onset}$ is the highest temperature at which any indication of superconductivity can be observed. The Mattheiss et al. paper reports that only samples prepared from starting material containing an excess of K (or Rb) and having been partially melted during preparation showed superconductivity.

The excitement in the scientific and technical community that was created by the recent advances in superconductivity is at least in part due to the potentially immense technological impact of the availability of materials that are superconducting at temperatures that do not require refrigeration with expensive liquid He. Liquid nitrogen is generally considered to be perhaps the most advantageous cryogenic refrigerant, and attainment of superconductivity at liquid nitrogen temperature was a long-sought goal which until very recently appeared almost unreachable.

Although this goal has now been attained, there still exists scientific as well as technological interest in the discovery of novel superconductive oxides. Such compounds would, of course, be of immense help in the elucidation of the mechanism responsible for the high transition temperatures observed in some of the oxide superconductors. Furthermore, among such novel compounds may be some that have a high transition temperature and/or show improvement in one or more properties, relative to currently known high $T_c$ materials. For instance, many of the currently known High $T_c$ materials have in bulk form relatively low current carrying capacity, especially in the presence of a magnetic field. These materials also tend to be brittle and at least some compounds (e.g., the well-known "1-2-3" compound $YBa_2Cu_3O_7$) are relatively unstable in the presence of water vapor, CO, etc. Consequently, an intense effort has been underway worldwide to discover new superconductive oxides. This application discloses such oxides, as well as improvements in the method of producing A-site substituted Bi-based oxide superconductors.

For a general overview of some potential applications of superconductors see, for instance, B. B. Schwartz and S. Foner, editors, Superconductor Applicants: SQUIDS and MACHINES, Plenum Press 1977; and S. Foner and B. B. Schwartz, editors, Superconductor Material Science, Metallurgy, Fabrications, and Applications, Plenum Press 1981. Among the applications are power transmission lines, rotating machinery, and superconductive magnets for e.g., fusion generators, MHD generators, particle accelerators, levitated vehicles, magnetic separation, and energy storage, as well as junction devices and detectors. It is expected that many of the above and other applications of superconductivity would materially benefit if oxidic superconductive material could be used instead of the previously considered superconductors.

## Brief Description of the Drawings

FIGS. 1 and 2 show data on the magnetization of exemplary materials according to the invention;

FIG. 3 shows data on the normal state susceptibility of exemplary material according to the invention;

FIG. 4 is a diagrammatic respresentation of a perovskite crystal lattice;

FIG. 5 schematically depicts an exemplary superconductive cable;

FIG. 6 schematically shows an exemplary superconductive magnet;

FIG. 7 schematically depicts elements of a fusion generation system with superconductive magnet coils; and

FIGS. 8 and 9 are schematic representations of superconductive thin film devices, a Josephson junction and a transmission lines, respectively.

## The Invention

In one broad aspect the invention is based on the discovery of extensions of the A-site substituted Bi-based superconductive oxides of Mattheiss et al., (op.cit). At least some members of the class of superconductors according to the invention are isotropic superconductors, and thus are not subject to the limitations imposed on prior art oxide superconductors that are anisotropic superconductors.

In particular, superconductive compositions according to the invention can be described by the formula $A_{n+i}Bi_nO_{3n+i\cdot\delta}$, where n is an integer greater than 0,(and typically less than 5 or 6) i = 0 or 1, A is $X_{1-x-y}M_xM'_y$ , where M is at least one monovalent or trivalent dopant atom species, M' is at least one monovalent, divalent, or trivalent stabilizer atom species selected from the A-site atoms, and X is at least one divalent atom species different from M and M', with A and Bi occupying essentially only A-sites and B-sites, respectively, and wherein $0 \leq \delta \leq 1$. The inventive compositions have $T_c^{onset}$ of at least about 22K. In some particular embodiments the composition has perovskite or perovskite-like crystal structure.

We have also discovered a method of producing compositions according to the invention that comprise Bi and at least one monovalent element in the ratio $1 = x_o$, the method comprising providing a precursor material that comprises Bi and at least one monovalent element in the ratio $1 : x_e$, where $x_e > x_o$, and heating the percursor material in a closed system such that a monovalent element partial pressure greater than about 10 atmospheres (about 1.01325 MPa) results.

Among others, we have discovered that it is advantageous to increase the (monovalent substituent): Ba ratio to the maximum consistent with maintenance of the essentially single phase (metallic) nature of the material. Exemplarily, we have observed improved superconductive properties (primarily higher $T_c^{onset}$ for samples of composition $Ba_{1-x}K_xBiO_{3-\delta}$ , where $0.3 \leq x \leq 0.5$, and $\delta$ is small, typically 0 $\leq \delta \leq 0.1$. These compositions can have $22K \leq T_c^{onset}$ , and we observed a maximum of 30K for x ~ 0.4. Improvements are also expected in the case of other alkali substituents, e.g., Rb and Cs, and possibly Li and Na, as well as combinations thereof. Since we currently believe that the monovalent A-site substituent (or substituents) supply free carriers (electrons or holes) to the material, we will, in analogy to the terminology used in the semiconductor art, refer to these substituents as "dopants".

We have also discovered that the presence of a further atomic species (to be referred to as the "stabilizer") on the A-site may, at least in some cases, result in increased stability of the perovskite-like metallic phase such that the dopant: Ba ratio can be further increased, without loss of the metallic character of the composition. The stabilizer is chosen from the class of so-called "A-site" atoms. For a definition of A-site atoms see "Wells Structural Inorganic Chemistry", Clarendon Press, Oxford 1984, pp. 584-589. Exemplary potential stabilizer elements for use in conjunction with monovalent dopants are the relatively large di- and trivalent species such as lanthanides, U, Sr, Ca, and combinations thereof.

More generally, the novel superconductive materials have composition $ABiO_{3-\delta}$, where A is $X_{1-x-y}M_xM'_y$, with M being a monovalent or trivalent dopant species, and M' being a mono-, di-, or trivalent stabilizer species. As will be recognized by those skilled in the art, a trivalent substituent can also supply carriers (electrons or holes) to the material, and thus such substituents are also properly referred to as "dopants". If M is monovalent then M' advantageously is di- or trivalent, if M is trivalent the M' advantageously is mono- or divalent. Exemplary of trivalent M are large rare earths such as La, Nd, and Pr. As before, $\delta$ is small typically between zero and about 0.1. X is one or more divalent element different from M', typically chosen from the group consisting of Ba, Sr, and Ca. Compositions according to the invention have relatively high transition temperatures, with $T_c^{onset}$ being greater than about 22K. As in all compositions discussed herein, members of A are located on A-sites, with B-sites being populated essentially only by Bi.

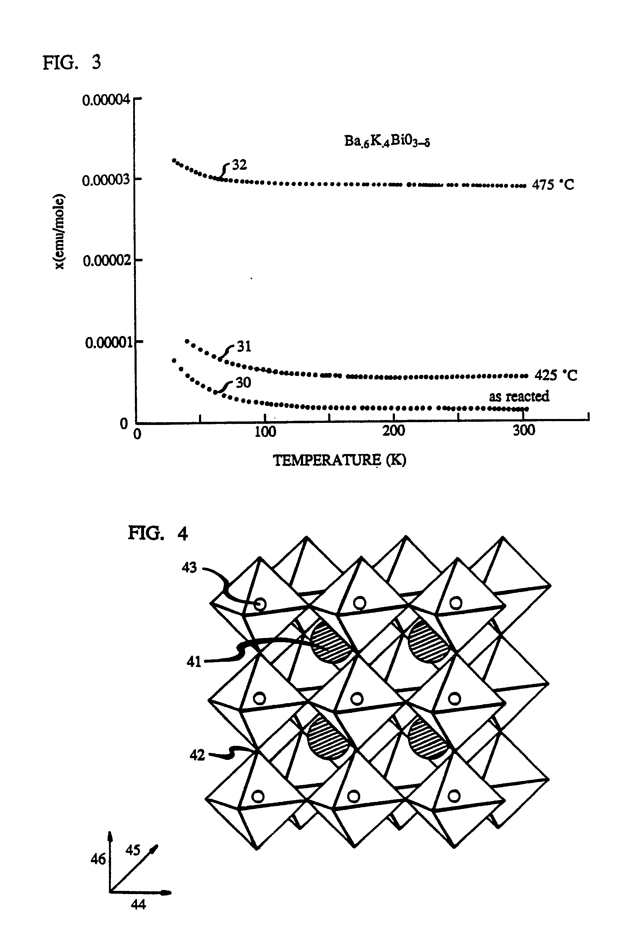

All the compositions of Mattheiss et al. have a perovskite-like crystal structure. FIG. 4 diagrammatically depicts an exemplary ideal perovskite lattice wherein the large spheres (designated 71) represent A-site occupants, the small spheres (73) represent B-site occupants, and oxygen atoms are located on the vertices 72 of the octohedra. Arrows 74, 75 and 76 represent the axes of the coordinate system conventionally used to described the perovskite structure.

As can be seen from FIG. 4, oxygen and the B-site species form a three dimensional network. The three dimensional network of Bi-O complexes is believed to be instrumental in the conduction process, both above and below $T_c$. Due to the isotropic nature of the network, the conductivity of these materials is expected to be isotropic, in contradistinction to that of such other oxide superconductors as $YBa_2Cu_3O_7$. Isotropic conductivity is expected to offer an advantage over strongly anisotropic conductivity in at least some cases. For instance, the former may make it easier to produce bulk samples having a relatively high critical current.

We are also disclosing novel A-site substituted Bi-based compositions which have a layered structure and which, we believe, are likely to contain materials having relatively high (greater than about 30K) transition temperatures. The novel compositions correspond to the general formula $A_{n+1}Bi_nO_{3n+1-\delta}$, wherein n is an integer greater than 1 (typically less than about 5 or 6), and with $\delta$ being close to zero, exemplarily less than 0.1. As before, A in the general case takes the form $X_{1-x-y}M_xM'_y$, where X, M, and M' are as defined above, and x and y are chosen such that the resulting material exhibits metallic conductivity, with $0 < x < 1, 0 \leq y < 1$, and $x + y < 1$. The structure of the materials is based on the structure depicted in FIG. 4, with planes consisting exclusively or largely of A atoms separating groups of n Bi-O layers (with A atoms in the A-sites) of the type schematically depicted in FIG. 4.

The inventive superconducting oxides frequently contain relatively volatile elements such as Na, K, Rb, Cs, and possibly Li. This is expected to require the use of novel manufacturing methods that minimize the loss of volatile constituents from the charge. Exemplarily this requires heating the starting materials (e.g. BaO, $KO_2$, and $Bi_2O_3$) in an essentially inert closed vessel, where by "inert" we mean that at the processing temperature the material of the vessel does not interact significantly with any of the elements or compounds in the charge, and in particular does not "poison" the superconductive oxide formed in the vessel. Heating in a closed vessel results in the presence of a relatively high-pressure vapor of the volatile element(s), and this is currently considered to be a significant aspect of the novel techniques. Although the details will depend on the composition to be prepared, we currently believe that attainment at some stage of the heat treatment of an alkali partial pressure of at least about 10 atm. is advantageous.

As an example of a novel processing technique used to produce a superconductor according to the invention, we produced single phase $Ba_{1-x}K_xBiO_3$ by heating mixed BaO, $KO_2$, and $Bi_2O_3$ in a sealed silver tube for three days at 675°C, followed by cooling of the sealed tube to room temperature. When the starting materials were mixed in the stoichiometric perovskite ratios then frequently only a few percent superconductivity was observed, even in materials which appeared single phase by X-ray diffraction. However, providing an excess of alkali in the starting mixture dramatically increased the amount of superconductivity in the resulting single phase perovskite material. The use of excess alkali is likely to be advantageous in general in the production of superconductive oxides according to the invention.

The above described heating of the exemplary mixed starting materials typically results in material that is red or brown in color and does not superconduct. The as-synthesized non-superconducting material has to be subjected to an appropriate oxygen treatment to produce superconducting material. Exemplarily such treatment comprises grinding of the as-synthesized material, followed by heating in flowing oxygen at 475°C for about 45 minutes, with subsequent relatively fast (e.g., 5 minutes) cooling to room temperature. It is considered important that all heat treatment of the as-synthesized material be carried out at a relatively low temperature and for relatively short times, selected such that alkali loss from the material is minimized.

The thus produced exemplary powder has deep blue/black color and can, for instance, be pressed into pellets or other useful shapes. It can also be used in substantially the same manner as prior art superconductive oxide powders, to produce tape or other bodies by conventional ceramic techniques, to form conductors on a substrate by screen printing or other appropriate technique, or to coat an elongate substrate (e.g., a Ag wire or ribbon). Advantageously "green" bodies are fired in a closed system, possibly under oxygen and/or elevated alkali pressure. It is also expected that the inventive superconductors can be deposited in thin film form, substantially in the manner of the prior art oxide superconductors. Exemplary methods for thin film deposition are well known to those skilled in the art, and comprise MBE, sputtering and evaporation.

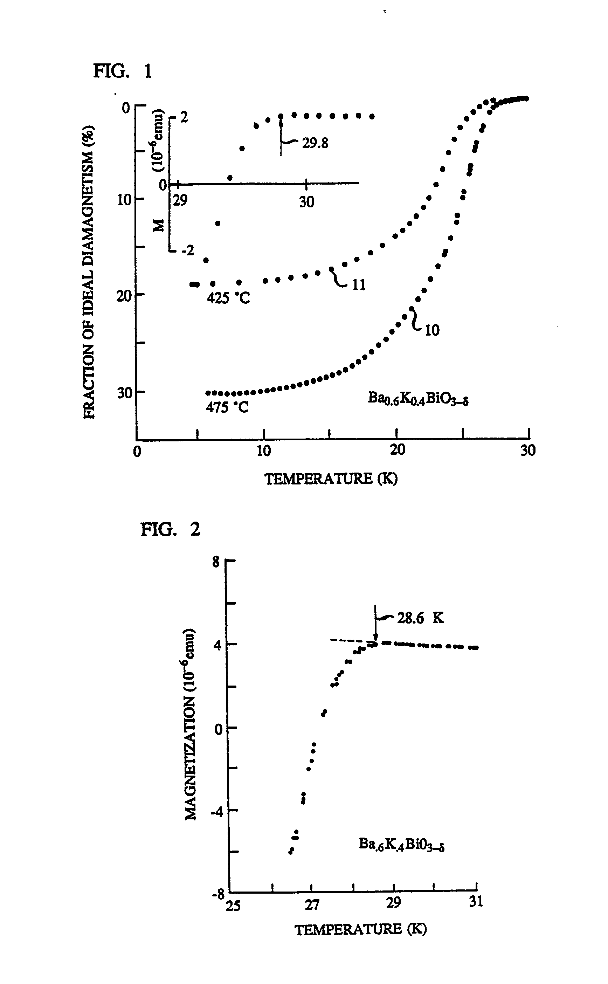

FIG. 1 shows data on the diamagnetism (compared to an analogous ideal diamagnetic sample, 19 Oe external field) of two exemplary samples of material according to the invention. Curve 10 pertains to a sample that was prepared from powder (of composition $Ba_{0.6}K_{0.4}BiO_{3-\delta}$) prepared as described above. Curve 11 pertains to a sample of the same composition but prepared from powder that was treated in flowing $O_2$ for 45 minutes at 425°C, as compared to 475°C for the above discussed sample. FIG. 1 also shows the magnetization of the 475°C sample on an expanded scale near $T_c^{onset} = 29.8K$. Both the 425°C and the 475°C material are essentially single phase perovskite material (cubic to within the resolution of the standard powder X-ray technique used to determine the crystal structure), having a lattice parameter $a_0$ near 4.28 Å, with the observed small difference in lattice parameter believed to reflect an increased oxygen uptake at the higher treatment temperature.

FIG. 2 presents data on the magnetization of a sample of composition $Ba_{0.6}Rb_{0.4}BiO_{3-\delta}$ that was prepared substantially as the 475°C K-containing sample of FIG. 1. As can be seen, use of Rb instead of K as a dopant results in a slightly lower $T_c^{onset}$. However, the Rb-containing sample had a substantially smaller volume fraction of superconductivity.

FIG. 3 shows data on the susceptibility of samples prepared from powder of composition $Ba_{0.6}K_{0.4}BiO_{3-\delta}$, as a function of temperature. Curve 30 pertains to a sample made from powder that was reacted at 675°C for three days in a sealed silver tube but which did not receive any subsequent heat treatment, whereas curves 31 and 32 pertain to samples prepared from powders which also were treated in $O_2$ at 425°C and 475°C, respectively. The Curie-Weiss-like contribution to the otherwise weakly paramagnetic susceptibility of the as reacted sample is believed to be due to the presence of a minor amount (about 0.1%) of unreacted $KO_2$. The small low temperature upturns observed in the other two samples are also believed to be due to the same cause.

Table 1

| Starting Mixture | Reaction Temperature(°C) | Reaction Time | Temp. of Oxygen Anneal | $T_c$ | % Diamagnetism |
|---|---|---|---|---|---|
| $Ba_{.7}K_{.45}BiO_3$ | 675 | 3 days | 475 | 29.2 | 20 |
| $Ba_{.7}K_{.6}BiO_3$ | 675 | 3 days | 475 | 29.8 | 25 |
| $Ba_{.65}K_{.52}BiO_3$ | 675 | 3 days | 425 | 28.3 | 20 |
| $Ba_{.65}K_{.7}BiO_3/$ | 675 | 3 days | 475 | 29.2 | 23 |
| $Ba_{.6}K_{.8}BiO_3/$ | 675 | 3 days | 425 | 28.0 | 20 |
| | | | 475 | 29.8 | 30 |
| $Ba_{.5}K_{.75}BiO_3/$ | 825 | 2.5hrs | 425 | 24.7 | 25 |
| | | | 475 | 26.5 | 24 |
| $Ba_{.6}Rb_{.6}BiO_3/$ | 675 | 3 days | 425 | 28.6 | 3 |
| $Ba_{.5}Rb_{.75}BiO_3/$ | 675 | 3 days | 425 | 28.5 | 5 |
| $Ba_{.5}Rb_{.75}BiO_3/$ | 825 | 2.5hrs | 425 | 25.5 | 6 |
| | | | 475 | 25.28 | 7 |

Table 1 presents a summary of reaction conditions and superconducting properties of exemplary Ba-(K, Rb)-Bi-O materials according to the invention. All of the materials were reacted in sealed Ag tubes. As will be noted, all the starting materials can have an excess of alkali. By this we mean that the starting material contains A-site atoms in excess of B-site atoms, with the ratio of dopant atoms to Ba being greater in the starting material than it is to be in the resulting inventive material.

The inventive materials can be processed into superconductive bodies in substantially the same way as prior art oxide superconductors, e.g., incorporated into a slurry and formed into bodies such as tape by ceramic techniques. They can also be incorporated into a paste, and a patterned superconductor formed on a substrate by silk screening and firing. A slurry can also be used to coat an appropriately inert wire (e.g., Ag wire) to produce a superconductive wire. Furthermore, it is expected that the inventive materials can be deposited in thin film form, e.g., by sputtering or evaporation of the metal constituents and oxidation of the deposit.

Superconductors according to he invention potentially are useful in many of the applications for which prior art superconductors were proposed or are used. FIGS. 3-6 illustrate exemplary potential applications.

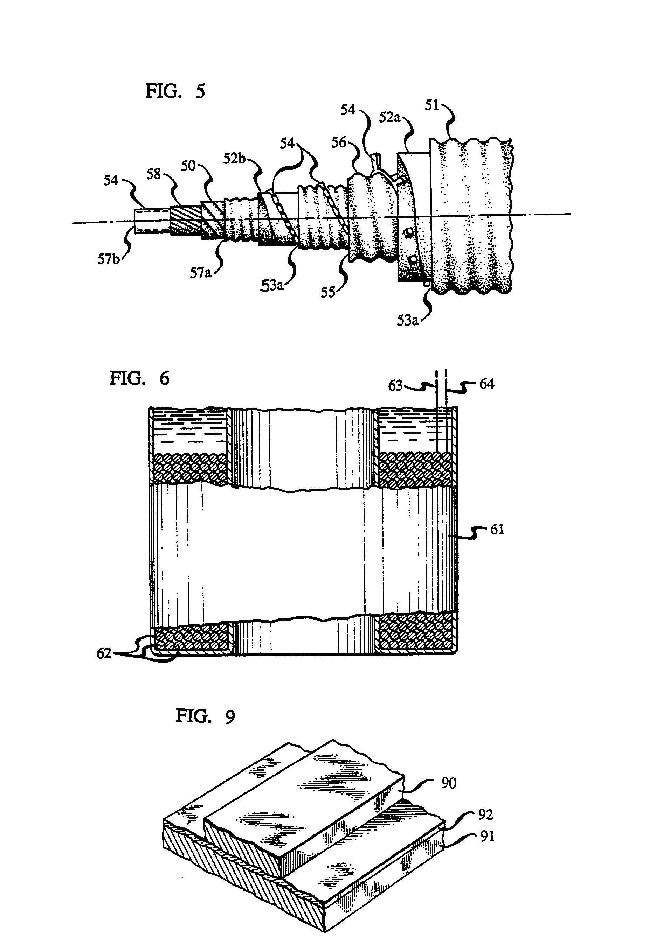

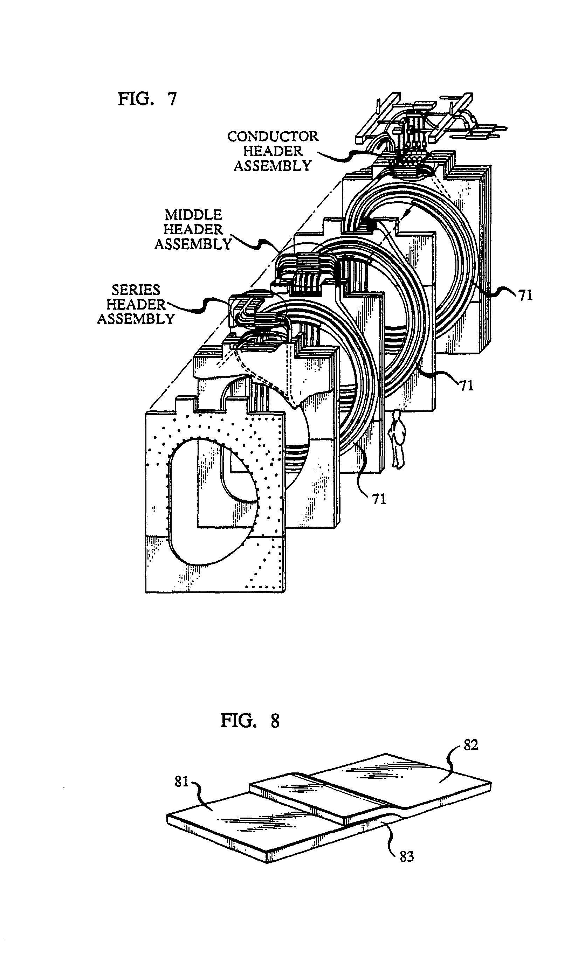

The structure shown in FIG. 5 is described in detail in G. Bogner, "Large Scale Applications of Superconductivity", in Superconductor Applications: SQUIDs and Machines, B. B. Schwartz and S. Foner, editors, (Plenum Press, New York, 1977). Briefly, the structure depicted consists of an outer sheathing 51, thermal insulation layers 52a and 52b, evacuated annular regions 53a and 53b, spacers 54, nitrogen-filled annular region 55, heat shield 56, and coolant regions 57a and 57b. Element 58 is a superconducting magnet comprising an annular cryostate 61 filled with an appropriate cryogenic liquid and containing turns 62 of a superconductive material according to the invention. Terminal leads 63 and 64 are shown emerging from the coil. The structure of FIG. 7 is described in R. A. Hein and D. U. Gubser, "Applications in the United States", in Superconductor Materials Science: Metallurgy, Fabrication, and Applications, S. Foner and B. B. Schwartz, editors, (Plenum Press, New York, 1981). The superconducting elements shown in FIG. 7 as windings 71 are made of a material herein. The structure of FIG. 7 is considered exemplary of those expected to find broad-scale use for containment of fusion reactions.

FIG. 8 schematically shows a superconductive thin film device, a Josephson junction. The structure consists of two superconducting layers 81 and 82 separated by a tunneling barrier 83. Use of material of the invention (not necessarily identical) for 81 and 82 may permit Josephson action at higher temperatures than would be possible with the prior art Bi-based oxide superconductors. Josephson junction devices are described in M. R. Beasley and C. J. Kircher "Josephson Junction Electronics: Materials Issues and Fabrication Techniques", in Superconductor Applications: SQUIDS and Machines.

FIG. 9 is a perspective view of a section of superconducting stripline. Structures of the type depicted may usefully serve as interconnections (rather than many-kilometer long distance transmission). It is structures of this type that are expected to permit operation at significantly increased speed of present commercial apparatus. The structure (which is depicted in Journal of Applied Physics, Vol. 49, No. 1, page 308, January 1978) consists of a superconducting strip 90 insulated from superconducting groundplane 91 by dielectric layer 92. Considerations entailed in dimensioning the structure depend upon intended use and are generally described in the above reference.

## Claims

1. Superconducting element comprising at least one superconductive composition, associated with the superconductive composition being a crystal structure comprising two inequivalent lattice sites (to be referred to as the A-site and the B-site, respectively), CHARACTERIZED IN THAT the superconductive composition has the formula $A_{n+i}Bi_nO_{3n+i-\delta}$, wherein n is an integer greater than 0, and less than about 6, i = 0 or 1, wherein A is $X_{1-x-y}M_xM'_y$, with M being at least one monovalent or trivalent dopant atom species, M' being at least one monovalent, divalent, or trivalent stabilizer atom species selected from the group consisting of the A-site atoms, and X is at least one divalent atom species different from M and M', with A and Bi occupying essentially only A-sites and B-sites, respectively, and wherein $0 \leq \delta \leq 0.1$, the superconductive composition having a transition temperature $T_c^{onset}$ of at least about 22K.

2. The element of claim 1, wherein i = 0 and n = 1, and the crystal structure is a perovskite or perovskite-like crystal structure.

3. The element of any of claims 1 or 2, wherein y = 0, and wherein M is chosen from the class consisting of Na, K, Rb, and Cs.

4. The element of any of claims 1, 2, or 3, wherein X is chosen from the class consisting of Ba, Sr, and Ca.

5. The element of claim 2, wherein x is Ba, M is K, and X is about 0.4.

6. Apparatus which depends for its operation on current through an element as described in any of claims 1-5.

7. A method of producing a superconductive oxide material comprising Bi and at least one monovalent element, the superconductive oxide to contain Bi and the monovalent element or elements in the ration 1 : $x_o$, the method comprising

a) providing a quantity of precursor material from which the superconductive oxide is to be formed, the precursor material comprising at least one Bi-containing constituent, and at least one constituent that contains the monovalent element or elements; CHARACTERIZED IN THAT

b) the precursor material contains Bi and the monovalent element or elements in substantially the ratio 1 : $x_e$, where $x_e$ is greater than $x_o$; and the method further comprises.

c) producing the superconductive oxide from the precursor material by a process that comprises heating the precursor material in a closed system such that a monovalent element partial pressure greater than about 10 atm. results.

FIG. 1

FIG. 2

EP 0 339 886 A2

FIG. 3

FIG. 4

FIG. 5

FIG. 6

FIG. 9

FIG. 7

CONDUCTOR
HEADER
ASSEMBLY

MIDDLE
HEADER
ASSEMBLY

SERIES
HEADER
ASSEMBLY

71

71

71

FIG. 8

81

82

83